# EUROPÄISCHE PATENTANMELDUNG

(11) **EP 1 393 983 A2**
(43) Veröffentlichungstag der Anmeldung: **03.03.2004**
(21) Anmeldenummer: 03018667.0
(22) Anmeldetag: 21.08.2003
(51) Int. Cl.: B60R 16/02

(54) **Baugruppe zur Kühlung eines Steuermoduls und einer Batterie**

(30) Priorität: 30.08.2002 DE 20213397 U
(71) Anmelder: TRW Automotive Electronics & Components GmbH & Co. KG, 67677 Enkenbach/Alsenborn (DE)
(72) Erfinder: Jatzke, Stefan, 67280 Ebertsheim (DE); White, Paul, Luton, Beds LU2 8SL (GB)
(74) Vertreter: Sties, Jochen, Dipl.-Ing.

(57) **Zusammenfassung**

Eine Baugruppe hat ein Gehäuse (10) für eine Batterie (16) und ein Steuermodul (18). Das Gehäuse hat einen Lufteinlaß (20, 20') und einen Luftauslaß (22), wobei der Luftauslaß (22) mit dem Ansaugsystem eines Motors eines Kraftfahrzeugs verbunden werden kann.

## Beschreibung

Die Erfindung betrifft eine Baugruppe zum Kühlen eines Steuermoduls und einer Batterie für ein Kraftfahrzeug.

Das Steuermodul und die Batterie sind üblicherweise im Motorraum des Fahrzeugs angeordnet. Anfallende Verlustwärme wird von der Umgebungsluft abgeführt, wobei die Durchströmung des Motorraumes mit steigender Fahrgeschwindigkeit ansteigt. Im Stillstand des Fahrzeugs wird der Motorraum jedoch nicht durchströmt, so daß das Steuermodul und die Batterie vergleichsweise schlecht gekühlt werden.

Die Aufgabe der Erfindung besteht darin, die Kühlung des Steuermoduls und der Batterie auch beim Stillstand des Fahrzeugs zu gewährleisten.

Zu diesem Zweck ist erfindungsgemäß eine Baugruppe mit den Merkmalen des Anspruchs 1 vorgesehen. Da die Verbrennungsluft des Motors des Fahrzeugs durch das Gehäuse hindurch angesaugt wird, in welchem das Steuermodul und die Batterie angeordnet sind, ist die Luftströmung entlang dem Steuermodul und der Batterie nicht mehr von der allgemeinen Durchströmung des Motorraumes abhängig, sondern es wird auch im Stillstand des Fahrzeugs ein Luftdurchsatz aufgrund der Luftansaugung durch den Motor gewährleistet.

Die Erfindung wird nachfolgend anhand zweier Ausführungsformen beschrieben, die in den beigefügten Zeichnungen dargestellt sind. In diesen zeigen:
- Figur 1 in einer Schnittansicht eine Baugruppe gemäß einer ersten Ausführungsform der Erfindung; und
- Figur 2 in einer Schnittansicht eine Baugruppe gemäß einer zweiten Ausführungsform.

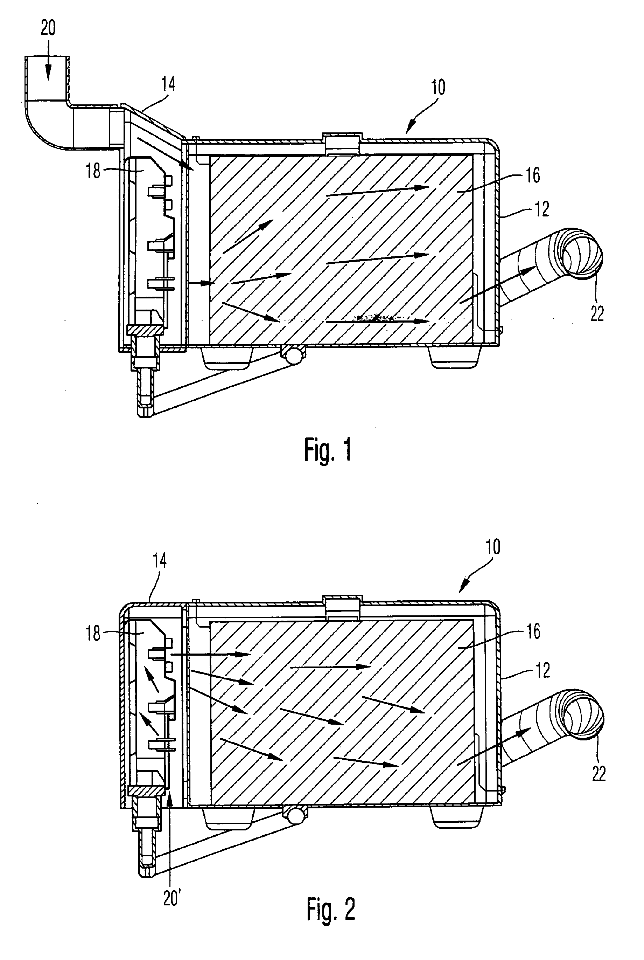

In Figur 1 ist ein Gehäuse 10 zu sehen, das aus einem Batteriegehäuse 12 und einem Steuermodul-Gehäuse 14 besteht. Im Batterie-Gehäuse 12 ist eine Batterie 16 angeordnet, und im Steuermodul-Gehäuse 14 ist ein Steuermodul 18 angeordnet. Das Gehäuse 10 besitzt einen Lufteinlaß 20, der hier unterhalb einer (nicht dargestellten) Frontscheibe des Fahrzeugs angeschlossen ist. Das Gehäuse 10 besitzt außerdem einen Luftauslaß 22, der an einen (nicht dargestellten) Luftfilter für einen Motor eines Kraftfahrzeugs angeschlossen ist.

Sobald der Motor läuft und Luft ansaugt, ergibt sich durch das Gehäuse 10 eine Luftströmung, die durch die eingezeichneten Pfeile angedeutet ist. Die Luft strömt ausgehend vom Lufteinlaß 20 durch das Steuermodul-Gehäuse 14, dann von diesem durch das Batterie-Gehäuse 12 und aus dem Gehäuse 10 heraus zum Luftauslaß 22. Dies gewährleistet eine Kühlung sowohl des Steuermoduls 18 als auch der Batterie 16 unabhängig von der Fahrgeschwindigkeit des Fahrzeugs.

Gemäß einer alternativen Ausgestaltung kann der Lufteinlaß 20 auch an eine Klimaanlage angeschlossen sein. Dies gewährleistet, daß bei hohen Außentemperaturen vorgekühlte Luft angesaugt wird, was die Kühlwirkung verbessert.

Das Batterie-Gehäuse 12 und das Steuermodul-Gehäuse 14 sind vorzugsweise so angeordnet, daß der Innenraum des Steuermodul-Gehäuses 14 nur von der Seite des Batterie-Gehäuses 12 aus zugänglich ist. Dies erschwert einen Diebstahl des Steuergerätes 18, da erst die Batterie 16 ausgebaut werden muß, um an das Steuergerät 18 zu gelangen.

In Figur 2 ist eine zweite Ausführungsform der Baugruppe gezeigt. Für die von der ersten Ausführungsform bekannten Bauteile werden dieselben Bezugszeichen verwendet, und es wird insoweit auf die obigen Erläuterungen verwiesen.

Der Unterschied zur ersten Ausführungsform besteht darin, daß bei der zweiten Ausführungsform die Luft direkt aus dem Motorraum angesaugt wird. Dementsprechend ist der Lufteinlaß 20' hier durch eine einfache Öffnung auf der Unterseite des Steuermodul-Gehäuses 14 gebildet.

## Patentansprüche

1. Baugruppe mit einem Gehäuse (10) für eine Batterie (16) und ein Steuermodul (18), wobei das Gehäuse einen Lufteinlaß (20, 20') und einen Luftauslaß (22) aufweist, wobei der Luftauslaß (22) mit dem Ansaugsystem eines Motors eines Kraftfahrzeugs verbunden werden kann.

2. Baugruppe nach Anspruch 1, **dadurch gekennzeichnet, daß** das Gehäuse (10) ein separates Batterie-Gehäuse (12) aufweist.

3. Baugruppe nach Anspruch 1 oder Anspruch 2, **dadurch gekennzeichnet, daß** das Gehäuse (10) ein separates Steuermodul-Gehäuse (14) aufweist.

4. Baugruppe nach einem der vorhergehenden Ansprüche, **dadurch gekennzeichnet, daß** der Lufteinlaß (20) Luft aus dem Bereich einer Windschutzscheibe des Fahrzeugs ansaugt.

5. Baugruppe nach einem der Ansprüche 1 bis 3, **dadurch gekennzeichnet, daß** der Lufteinlaß (20) Luft von einer Klimaanlage ansaugt.

6. Baugruppe nach einem der Ansprüche 1 bis 3, **dadurch gekennzeichnet, daß** der Lufteinlaß (20') Luft aus dem Motorraum ansaugt.

7. Baugruppe nach einem der vorhergehenden Ansprüche, **dadurch gekennzeichnet, daß** die Batterie (16) stromabwärts vom Steuermodul (18) angeordnet ist.

8. Baugruppe nach einem der vorhergehenden Ansprüche, **dadurch gekennzeichnet, daß** das Steuermodul (18) erst nach Ausbau der Batterie (16) zugänglich ist.
